Europäisches Patentamt

European Patent Office

Office européen des brevets

(19)

(11) **EP 1 496 521 A1**

(12) **EUROPEAN PATENT APPLICATION**

(43) Date of publication:
   **12.01.2005 Bulletin 2005/02**

(51) Int Cl.⁷: **G21K 1/06**, G02B 1/00,
   G02B 5/18

(21) Application number: **03077155.4**

(22) Date of filing: **09.07.2003**

(84) Designated Contracting States:
   **AT BE BG CH CY CZ DE DK EE ES FI FR GB GR
   HU IE IT LI LU MC NL PT RO SE SI SK TR**
   Designated Extension States:
   **AL LT LV MK**

(71) Applicant: **ASML Netherlands B.V.
   5504 DR Veldhoven (NL)**

(72) Inventor: **The designation of the inventor has not
   yet been filed**

(74) Representative: **Jorritsma, Ruurd
   Nederlandsch Octrooibureau
   Postbus 29720
   2502 LS Den Haag (NL)**

(54) **Mirror and lithographic apparatus with mirror**

(57)     The invention is relates to a mirror, having a mirroring surface, wherein the mirroring surface comprises one or more protrusions comprising a material selected from at least one of Be, B, C, P, S, K, Ca, Sc, Br, Rb, Sr, Y, Zr, Nb, Mo, Ba, La, Ce, Pr, Pa and U, or wherein the mirroring surface comprises one or more first protrusions comprising a first material selected from at least one of Be, B, C, P, S, K, Ca, Sc, Br, Rb, Sr, Y, Zr, Nb, Mo, Ba, La, Ce, Pr, Pa and U, and one or more second protrusions comprising a second material selected from at least one of Be, B, C, Si, P, S, K, Ca, Sc, Br, Rb, Sr, Y, Zr, Nb, Mo, Ba, La, Ce, Pr, Pa and U, and wherein the first and second materials are not the same. The inventions is further related to a lithographic projection apparatus comprising such mirrors. The invention also relates to a device manufacturing method using such lithographic apparatus.

# Fig 2

## Description

The present invention relates to a mirror, having a mirroring surface. The invention is further related to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- one or more mirrors, each mirror having a mirroring surface. The present invention also relates to a device manufacturing method using such lithographic apparatus and a device manufactured by such method or apparatus.

In a lithographic apparatus the size of features that can be imaged onto the substrate is limited by the wavelength of the projection radiation. To produce integrated circuits with a higher density of devices, and hence higher operating speeds, it is desirable to be able to image smaller features. Whilst most current lithographic projection apparatus employ ultraviolet light generated by mercury lamps or excimer lasers, it has been proposed to use shorter wavelength radiation, e. g. of around 13 nm. Such radiation is termed extreme ultraviolet (EUV) or soft x-ray, and possible sources include, for instance, laser-produced plasma sources, discharge plasma sources, or synchrotron radiation from electron storage rings.

Some extreme ultraviolet sources, especially plasma sources, emit radiation over a wide range of frequencies, even including infrared (IR), visible (VIS), ultraviolet (UV) and deep ultraviolet. These undesired frequencies will propagate and cause heating problems in the illumination and projection systems and cause undesired exposure of the resist if not blocked; although the multilayer mirrors of the illumination and projection systems are optimised for reflection of the desired wavelength, e.g. 13 nm, they are optically flat and have quite high reflectivities at IR, visible and UV wavelengths. It is therefore necessary to select from the source a relatively narrow band of frequencies for the projection beam. Even where the source has a relatively narrow emission line, it is necessary to reject radiation out of that line, especially at longer wavelengths. It has been proposed to use a thin membrane as a filter to perform this function. However, such a film is very delicate and becomes very hot, 200-300 °C or more, leading to high thermal stresses and cracking, sublimation and oxidation in the high power levels necessary in a lithographic projection apparatus. A membrane filter also generally absorbs at least 50% of the desired radiation.

EP1197803 describes a lithographic projection apparatus wherein a grating spectral filter is used in the radiation system of the lithographic projection apparatus. This grating spectral filter is designed for passing radiation of desired wavelengths to form a projection beam and for deflecting radiation of undesired wavelengths. The grating spectral filter is substantially formed of a material having a complex refractive index close to unity at the desired wavelengths and comprises silicon protrusions. The protrusions have a laminar sawtooth profile or a laminar square wave profile (Figures 3 and 4 of EP 1197803, respectively), and are present on a mirror, having a mirroring surface.

A disadvantage is that Si does not block IR radiation very well. Hence, it is an object of the present invention to provide an improved mirror that can be used as optical filter that may be used in a lithographic projection apparatus to select EUV radiation from a wide band source and/or to reject undesired frequencies and with which e.g. IR radiation is more effectively blocked.

According to the present invention, there is provided a mirror according to the opening paragraph, characterised in that the mirroring surface comprises one or more protrusions comprising a material selected from at least one of Be, B, C, P, S, K, Ca, Sc, Br, Rb, Sr, Y, Zr, Nb, Mo, Ba, La, Ce, Pr, Pa and U.

In a further aspect of the invention, there is provided a lithographic projection apparatus according to the opening paragraph, characterised in that at least one of the mirrors comprises a mirror according to the invention, i.e. a mirror, having a mirroring surface that comprises one or more protrusions comprising a material selected from at least one of Be, B, C, P, S, K, Ca, Sc, Br, Rb, Sr, Y, Zr, Nb, Mo, Ba, La, Ce, Pr, Pa and U. Combinations of materials can also be chosen, and also other materials, that are transmissive for EUV radiation, can be chosen.

The advantage of such a mirror or such an apparatus is that when EUV radiation is reflected by the mirror, e.g. under a certain angle, only the desired EUV radiation is reflected in this angle, whereas undesired radiation, for example IR radiation, is absorbed or substantially absorbed by the above mentioned materials and/or is deflected or refracted in other directions.

In one embodiment of the invention, the mirror has a mirroring surface with protrusions, wherein the protrusions are arranged in a regular pattern. This can for example be a mirroring surface wherein the protrusions are arranged to form a (blazed) grating, e.g. a 1D grating (e.g. laminar arranged lines or sawtooth profile) or a 2D grating (e.g. regular arranged cubes). Hence, the invention also comprises a mirror, having a mirroring surface wherein the protrusions are arranged to form a (blazed) grating profile.

In a further embodiment, the invention comprises a mirror (having a mirroring surface) wherein the mirror is a grazing incidence mirror, or wherein the mirror is a multilayer mirror, e.g. like those described in EP 1197803.

In an embodiment of the invention, the protrusions are arranged in such a way that a part of EUV radiation of a projection beam comprising EUV radiation, having an angle of incidence between 0 and 90°, only passes one protrusion. This leads to a minimum of loss of the desired radiation, whereas the radiation with wavelengths that are less desired is substantially blocked by the absorption, refraction or deflection of this radiation by the protrusions. A characteristic angle is e. g. between about 75 to 85° for a grazing incidence (GI) mirror. The angle of incidence is measured with respect to the normal of the mirroring surface.

In a further embodiment, the protrusions are arranged in such a way that a part of EUV radiation of a projection beam comprising EUV radiation, having an angle of incidence between 0 and 90°, only passes one protrusion, and wherein the protrusions, having a length and a period, are arranged in such a way that the length of the protrusions << the period of the protrusions (the length of a protrusion is substantially smaller than the period). For example, the ratio length of a protrusion : period is equal or smaller than 1:5 (period is 5 times the length of the protrusion), e.g., or equal or smaller than 1:10, or equal or smaller than 1:20. In this way, possible diffractive loses of the desired radiation at the top surfaces of the protrusions are minimised, and the projection beam may pass exactly only one protrusion.

In another embodiment, the invention comprises a lithographic apparatus wherein one or more of the mirrors are arranged close to the radiation system, e.g. on the surface of a radiation collector, or on a grazing incidence mirror, or on a multilayer mirror, which are positioned after the radiation source.

According to a further aspect of the invention, there is provided a device manufacturing method comprising:

- providing a substrate that is at least partially covered by a layer of radiation-sensitive material;
- providing a projection beam of radiation using a radiation system;
- using patterning means to endow the projection beam with a pattern in its cross-section; and
- providing one or more mirrors, each mirror having a mirroring surface,

characterised by providing in the projection beam (PB) at least one of the mirrors comprising a mirror according to the invention, i.e. a mirror, having a mirroring surface that comprises one or more protrusions comprising a material selected from at least one of Be, B, C, P, S, K, Ca, Sc, Br, Rb, Sr, Y, Zr, Nb, Mo, Ba, La, Ce, Pr, Pa and U.

The advantage of this method is that when radiation is reflected by the mirror, e.g. under a certain angle, only the desired radiation is reflected in this angle, whereas undesired radiation, for example IR radiation, is absorbed by above mentioned materials and/or is reflected or refracted in other directions. This leads to better results, e.g. with respect to spatial resolution of the projection beam on the layer of radiation-sensitive material. A further advantage is that the materials of which the protrusions are made are not restricted to materials having a real part of the index of refraction for EUV radiation (e.g. about 13 nm) close to unity (Si for EUV radiation), as this is the case for EP 1197803. For EP 1197803 requires that the protrusions are invisible, i.e. there is no change of index of refraction from vacuum into protrusion (and vice versa), and thus, the protrusions should have an index of refraction close to unity.

In a next aspect of the invention, there is provided a mirror according to the opening paragraph, wherein the mirroring surface comprises one or more first protrusions comprising a first material, and comprising one or more second protrusions comprising a second material, and wherein the first and second materials are not the same. Such a mirror can be used, for example as normal incidence mirror or as grazing incidence mirror, to reflect desired wavelengths, but to block undesired wavelengths. This can e.g. be advantageous, when a laminar protrusion profile is present, and one wants to compensate for a possible difference in optical path lengths of radiation that propagates through a protrusion. Hence, the invention also comprises an embodiment, which comprises a mirror having a mirroring surface comprising first and second protrusions, wherein the first protrusions and second protrusions are arranged in such a way that for desired radiation an optical path length difference is created that does not vary over the mirroring surface. This means that the optical pathlength difference over the mirroring surface is zero or varies only an integer times the wavelength. The laminar protrusion profile may form a grating blazed or optimised for the desired wavelength, and the materials of the protrusions may be transparent or substantially transparent for the desired wavelength.

Hence, in a specific embodiment, the invention also comprises a mirror, having a mirroring surface, wherein the mirroring surface comprises one or more first protrusions comprising a first material, and comprising one or more second protrusions comprising a second material, wherein the materials of the first and second protrusions are not the same, wherein the materials are substantially transparent for the desired radiation, and wherein the protrusions are arranged to form a grating. By selecting parameters like e.g. the materials (index of refraction), heights and/or shape, distance (period) of the first and second protrusions, and a certain angle of incidence of the projection beam on the mirror, a mirror can be obtained that reflects the desired radiation while correcting by the different materials the optical path length difference of the propagating radiation of the desired wavelength(s), such that it does not vary over the mirroring surface. In a further embodiment this grating is a blazed grating.

In a specific embodiment, there is provided a mirror, wherein the mirroring surface comprises one or more first protrusions comprising a first material selected from at least one of Be, B, C, P, S, K, Ca, Sc, Br, Rb, Sr, Y, Zr, Nb, Mo, Ba, La, Ce, Pr, Pa and U, and one or more second protrusions comprising a second material selected from at least one of Be, B, C, Si, P, S, K, Ca, Sc, Br, Rb, Sr, Y, Zr, Nb, Mo, Ba, La, Ce, Pr, Pa and U, and wherein the first and second materials are not the same. Such mirror is advantageous for selecting desired EUV wavelengths from a beam of radation, and deflecting or absorbing radiation of undesired wavelengths like UV, visible or IR.

These (first and second) materials are in an embodiment substantially transparent for EUV radiation of e.g. about 13.5 nm. The materials can be arranged in different ways, e.g. as a sawtooth profile, in which the different materials are on top of each other, or in a block profile, in which the materials are arranged next to each other. As mentioned above, the different heights of the materials may be chosen in such a way, that under a certain angle, at every position the sum of the phase shifts which are induced by the different materials is the same (or substantially the same) for the radiation that has to be transmitted. Hence, the invention also comprises an embodiment, comprising a mirror having a mirroring surface comprising first and second protrusions, wherein the first protrusions and second protrusions are arranged in such a way that for EUV radiation an optical path length difference is created that does not vary over the mirroring surface.

In a further aspect of the invention, there is provided a lithographic projection apparatus according to the opening paragraph, characterised in that at least one mirroring surface comprises one or more first protrusions comprising a first material selected from at least one of Be, B, C, P, S, K, Ca, Sc, Br, Rb, Sr, Y, Zr, Nb, Mo, Ba, La, Ce, Pr, Pa and U, and comprising one or more second protrusions comprising a second material selected from at least one of Be, B, C, Si, P, S, K, Ca, Sc, Br, Rb, Sr, Y, Zr, Nb, Mo, Ba, La, Ce, Pr, Pa and U, and wherein the first and second materials are not the same. An advantage of a lithographic apparatus comprising such mirror is that more radiation having undesired wavelengths or a broader spectrum of radiation having undesired wavelengths can be blocked with this mirror.

The invention also comprises a method wherein one or more of such mirrors are used. In a further embodiment, the invention comprises a method, wherein one or more mirrors are provided in such a way in a projection beam comprising EUV radiation, having an angle of incidence between 0 and 90°, that part of the EUV radiation only passes one first and one second protrusion. In another embodiment, the first protrusions and second protrusions are arranged in such a way that for EUV radiation an optical path length difference is created that does not vary over the mirroring surface. This means that possible optical path length differences of the desired radation within the projection beam is zero or an integer times the wavelength.

According to further aspect of the invention, there is provided a device which is manufactured according to the method of the invention or with the apparatus according to the invention.

In the invention, "protrusions", which are present on the mirroring surface, are defined as structures extending from the mirroring surface that may comprise a material selected from at least one of Be, B, C, P, S, K, Ca, Sc, Br, Rb, Sr, Y, Zr, Nb, Mo, Ba, La, Ce, Pr, Pa and U. These protrusions may e.g. be made via lithographic techniques. In such a technique, the upper surface is polished to a very good surface roughness and grooves are etched with the lands defined by a photoresist pattern. In this way, a certain profile is obtained, e.g. laminar block or laminar sawtooth. The profile may also be provided by ruling (scratching a line) a layer of a (first) material with a diamond tool.

The protrusions may have a laminar sawtooth profile, wherein the protrusions have a sawtooth profile that is laminarly arranged on a (mirroring) surface. The profile can be arranged to form a (blazed) 1D grating, with a certain number of parallel lines (laminar sawtooth protrusions). The protrusions may also have a laminar square wave profile, wherein the protrusions have a square or rectangle structure, that is laminarly arranged on a (mirroring) surface. The profile can be arranged to form a 1D grating, with a certain number of parallel lines (laminar square wave protrusions).

The protrusions might also be periodically arranged in 2 directions. For example, the protrusions may have periodically structured sawtooth profile, wherein the protrusions can e.g. be cubes or rectangles which have a sawtooth profile in one direction, and which are periodically arranged, like a checkerboard. The profile can be arranged to form a (blazed) 2D grating, with a certain number of periodically arranged structures (periodical sawtooth protrusions). A further embodiment of a periodically arranged profile in 2 directions is a structure with a periodically structured square wave profile, wherein the protrusions can e.g. be cubes or rectangles which are periodically arranged, like a checkerboard. The profile can be arranged to form a (blazed) 2D grating, with a certain number of periodically arranged cubes or rectangles (periodical square wave protrusions). When using such 2D profiles, the protrusions are arranged in a kind of block structure of sawtooth protrusions (free standing periodical sawtooth protrusions) or block protrusions (free standing periodical square wave protrusions; with cubes or rectangles), as known to the person skilled in the art (e.g. US 6469827 or E. Hecht, "Optics", second edition, p. 430 (paragraph 10.2.7)).

"Transmissive" or "substantially transmissive" in this context means that the transmission through a protrusion is at least 70%, preferably at least 80%, at least 90% or at least 95%, more preferably 98%. "Not absorbed" or "substantially not absorbed" in this context means that the absorption of radiation is less than 30%, preferably less than 20%, less than 10% or less than 5%, more preferably less than 2%.

"Undesired radiation" or "undesired wavelength" refers to radiation having wavelengths larger (or smaller) than the wavelength that is intended to be used. For example, when EUV radiation with a wavelength of about 13.5 nm is desired, radiation with a wavelength smaller than about 10 nm or larger than about 20 nm is not desired. In a further embodiment, when EUV radiation with a wavelength of about 13.5 nm is desired, radiation with a wavelength smaller than about 13 nm or larger than about 14 nm is not desired, and thus wavelengths between 13 and 14 nm are desired wavelengths. The better the spectral separation, the better results and products can be obtained with a lithographic apparatus, that comprises a mirror according to the invention. In the present invention, with "reflecting unwanted wavelengths" or "reflecting undesired wavelengths", or equivalents thereof is meant that radiation with unwanted (or undesired) wavelengths is reflected.

In the present invention, calling a protrusion "first" and "second" protrusion is only a method to indicate the different protrusions of different materials. These terms do not imply a certain order.

The phrase "passing one protrusion" or "passing exactly one protrusion" refers to the situation that substantially all radiation of the projection beam, especially the radiation with desired wavelengths, passes through one protrusion. However, due to some divergence of the beam, it cannot be excluded that some radiation does not pass (only) one protrusion.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm or, when applicable, even shorter wavelengths), but especially radiation which has a wavelength less than 20 nm (EUV radiation), more preferably about 13.5 nm.

Embodiments of the invention will now be described, by way of example only, with reference to the accompanying schematic drawings in which corresponding reference symbols indicate corresponding parts, and in which:

- Figure 1 schematically depicts a lithographic projection apparatus according to an embodiment of the invention;
- Figure 2 schematically shows a side view of an EUV illumination system and projection optics of a lithographic projection apparatus according to Figure 1.
- Figure 3 schematically shows a mirror with on the mirroring surface protrusions in the form of a laminar sawtooth profile.
- Figure 4 schematically shows a mirror with on the mirroring surface protrusions in the form of a laminar square wave profile.
- Figure 5 schematically depicts a similar mirror as shown in Figure 4, but wherein the protrusions are arranged in such a way that a part of EUV radiation of a projection beam comprising EUV radiation, only passes one protrusion.
- Figure 6 schematically depicts the same mirror as shown in Figure 3, but in which the protrusions are now arranged to form a diffractive grating for EUV radiation, having a laminar sawtooth profile (blazed grating).
- Figure 7 schematically depicts the same mirror as shown in Figure 4, but in which the protrusions are now arranged to form a diffractive grating for EUV radiation, having a laminar square wave profile.
- Figure 8 schematically shows a mirror with on the mirroring surface protrusions in the form of a laminar sawtooth profile of two materials on top of each other.
- Figure 9 schematically shows a mirror with on the mirroring surface protrusions in the form of a laminar square wave profile of two materials next to each other.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;

- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localised electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and

- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

### *Embodiment 1*

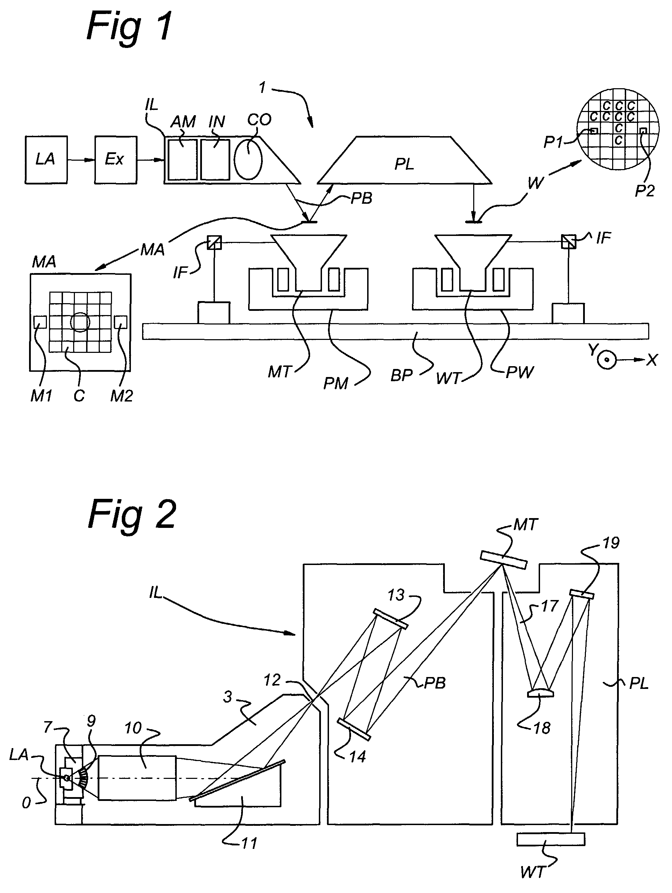

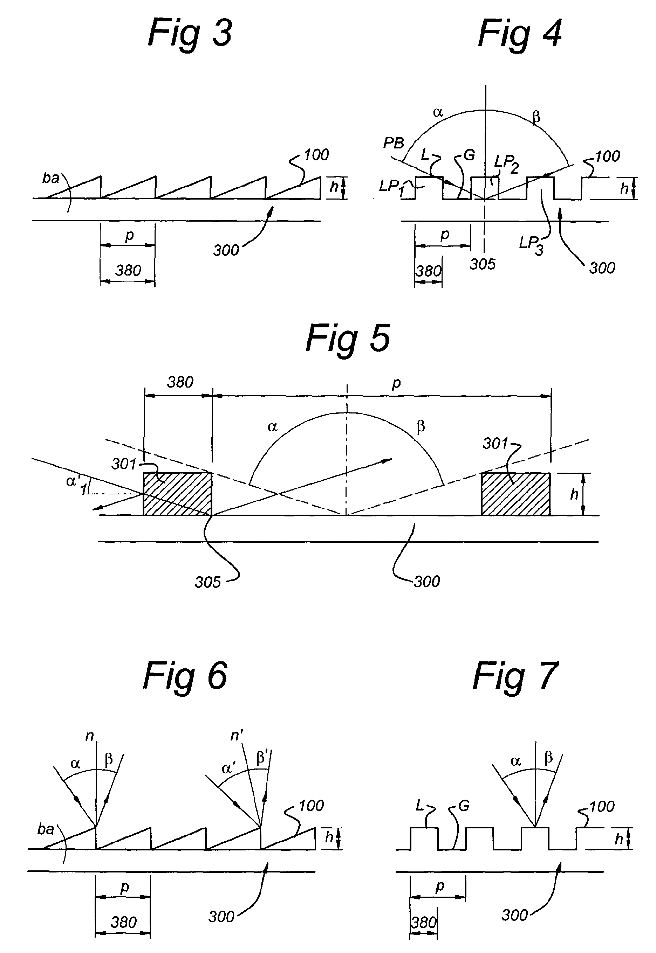

In this embodiment, a lithographic apparatus is described in general with reference to figures 1 and 2; the mirror of the invention is described in general with reference to figures 3 and 4.

Figure 1 schematically depicts a lithographic projection apparatus 1 according to a particular embodiment of the invention. The apparatus comprises:

- a radiation system LA (comprises a radiation source), a beam expander Ex, and an illumination system IL, for supplying a projection beam PB of radiation (e.g. 157 nm radiation);
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e. g. a resist-coated silicon wafer), and connected to second positioning means PW for accurately positioning the substrate with respect to item PL; and
- a projection system ("lens") PL (e.g. refractive, catadioptric or reflective optics) for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. an EUV excimer source or a plasma discharge source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus, but that it may also be remote from the lithographic projection apparatus, the radiation beam which it produces being led into the apparatus (e.g. with the aid of suitable directing mirrors); this latter scenario is often the case when the source LA is a laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realised with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed $V = Mv$, in which M is the magnification of the lens PL (typically, $M = 1/4$ or $1/5$). In this manner, a relatively large target portion C can be exposed, without having to compromise on resolution.

The radiation source LA, comprising a radiation source, illumination system IL and projection system PL may be contained in respective compartments ("boxes") which are evacuated or flushed with a gas transparent to the radiation of the projection beam. The projection beam is passed between the different compartments through openings in their walls. An example of an arrangement for passing the projection beam PB from the radiation source LA to illumination system IL is shown in greater detail in Figure 2.
Figure 2 shows an embodiment of the lithographic projection apparatus 1 of Figure 1, comprising a radiation system 3 (i.e. "source-collector module"), an illumination system IL, and a projection system PL. The radiation system 3 is provided with radiation source LA which may comprise a discharge plasma source. The radiation source LA may employ a gas or vapour, such as Xe gas or Li vapour in which a very hot plasma can be created by a discharge between electrodes of the radiation source to emit radiation in the EUV range of the electromagnetic spectrum. The very hot plasma is created by causing a partially ionised plasma of an electrical discharge to collapse onto an optical axis 0. Partial pressures of 0.1 mbar of Xe, Li vapour or any other suitable gas or vapour may be required for efficient generation of the radiation.

When xenon is used, the plasma may radiate in the EUV range around 13.5 nm. The radiation emitted by the radiation source LA may be led from a source chamber 7 to a contaminant barrier 9. The contaminant barrier 9 may comprise a channel structure such as, for instance, described in detail in European patent application EP-A-1 057 079.

Radiation system 3 (i.e. "source-collector module") comprises a radiation collector 10 which may be formed by a grazing incidence collector. Radiation passed by the radiation collector 10 is reflected off a grating spectral filter or mirror 11 to be focused in a virtual source point 12 at an aperture. The projection beam PB is reflected in the illumination system IL via normal incidence reflectors 13, 14 onto a reticle or mask positioned on reticle or mask table MT. A patterned beam 17 is formed which is imaged in projection optics system PL via reflective elements 18, 19 onto wafer stage or substrate table WT. More elements than shown may generally be present in illumination system IL and projection system PL.

One or more of the mirrors of Figure 2, e.g. the spectral filter or mirror on position 11, the radiation collector 10, or the normal incidence reflectors 13, 14 of Figure 2, can be a mirror according to the invention, and have a laminar protrusion profile, e.g. like a 1D profile with protrusions on the mirroring surface comprising a material selected from at least one of Be, B, C, P, S, K, Ca, Sc, Br, Rb, Sr, Y, Zr, Nb, Ba, La, Ce, Pr, Pa, U and Mo, as will be explained hereinafter.

An embodiment of the mirror of the invention is shown in Figure 3, wherein a kind of laminar sawtooth profile is shown, and wherein the protrusions have a period p, a length 380, a height h, and an angle ba. Figure 4 depicts another embodiment with a protrusion profile having a laminar square wave profile, wherein the protrusions have a period p, a length 380, and a height h. Reference L refers to "land" and reference G refers to "groove". The protrusions are arranged on a mirroring surface of mirror 300.

The advantage of such a mirror or an apparatus comprising such mirror is that when EUV radiation is reflected by the mirror 300, e.g. under a certain angle, only the desired EUV radiation is reflected in this angle, whereas undesired radiation, for example IR radiation, is absorbed by above mentioned materials and/or is deflected or refracted in other directions. By way of example, this is illustrated in figure 4. The projection beam PB, having an angle of incidence $\alpha$ hits the surface of a protrusion LP1 (laminar protrusion 1). Part of the light might be reflected (not shown) and part of the light, or all light might enter the protrusion. Since the protrusion is transmissive for EUV radiation, this radiation propagates unabsorbed or substantially unabsorbed, whereas radiation with undesired wavelengths like UV or IR is substantially absorbed. The beam may further propagate to the next protrusion (second protrusion), indicated with laminar protrusion LP2. Reaching the (left) surface of this protrusion LP2, part of the radiation might again be reflected (not shown), and part of the radiation will propagate through protrusion LP2. Also this protrusion LP2 will discriminate between EUV radiation and radiation with other wavelengths. When the projection beam PB reaches the surface of the mirror 300 (e.g. a multilayer mirror) at position 305, the projection beam PB is reflected with an angle $\beta$ ($\beta$ may be $\alpha$ in case of specular reflection on the surface of mirror 300). The projection beam PB may propagate further through protrusions LP2 and LP3. In this way, the projection beam PB will comprise a higher EUV/non-EUV radiation ratio after reflection by the mirror of the invention than before the incidence on the mirror. What has been illustrated in figure 4 with respect to the propagation of the projection beam PB may also apply for figure 3, where instead of laminar protrusions forming a laminar square wave profile like in Figure 4, a laminar sawtooth profile is used.

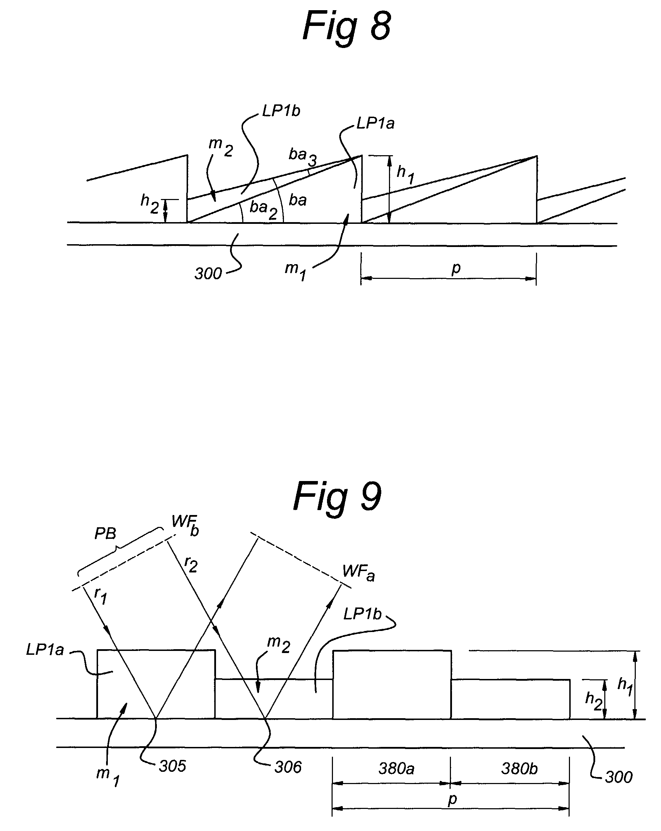

Note that refraction of the projection beam PB is not depicted in Figures 3 and 4 (and later Figures 5 and 9). The above-mentioned ratio may further be improved by using a blazed or optimised grating (see embodiment 3). The mirror with the above-mentioned protrusions can, even when it is optimised or blazed at e. g. UV wavelengths, block undesired wavelengths (like IR), but transmit EUV radiation, since Be, B, C, P, S, K, Ca, Sc, Br, Rb, Sr, Y, Zr, Nb, Mo, Ba, La, Ce, Pr, Pa and U are substantially transmissive for EUV radiation, but substantially not transmissive for radiation having other wavelengths than EUV radiation. Next to that, all these materials, including Si, have an absorption length longer than 100 nm for 13.5 nm. The protrusions can also comprise combinations of materials, like e.g. $B_4C$ or SiC.

The protrusions on mirror 300 of this embodiment are mainly present as optical filter that is transmissive for EUV radiation, and a possible grating or diffractive structure, is substantially transmissive for the EUV radiation of the projection beam PB. However, due to the difference in indices of refraction when the EUV radiation enters and leaves the protrusion, there may be some diffractive losses of the EUV radiation of the projection beam PB. This might be solved by other embodiments, e.g. embodiment 3, 4 and 7.

### *Embodiment 2*

In a second embodiment, the protrusions are arranged in such a way that a part of EUV radiation of a projection beam comprising EUV radiation, having an angle of incidence between 0 and 90°, only passes one protrusion, see Figure 5, or substantially every part of the projection beam PB passes only one protrusion.

The profile (which might be diffractive and optimised at e.g. about 13.5 nm or other EUV wavelengths) is constructed such that the desired radiation comprised in radiation beam PB only passes one period p of the profile and is reflected at the mirror or mirror surface 300 at e.g. position 305. The angle of incidence of the projection beam PB with mirror 300 is indicated with reference $\alpha$, whereas the angle of incidence of the projection beam PB with a side surface of a protrusion is shown as $\alpha'_1$. The angle of incidence $\alpha'_1$ may remain small to minimise reflection of the projection beam PB. Also, the upper surface of the protrusions of the profile can be angled, as in a blazed grating, so that the reflection of the undesired radiation (e.g. with wavelengths higher than EUV, e.g. UV VIS and IR) on the protrusion surface is directed in a different direction than the desired radiation. The length 380 and height h of the protrusions, the period p in which the protrusions are arranged, as well as the angle of incidence $\alpha$, may be chosen such that the projection beam PB only passes one protrusion.

The profile on the mirror can be produced by ruling (scratching a line) with a diamond tool. It is also possible to produce the profile by ion etching of a sinusoidal structure. Producing a block profile on a grazing incidence-mirror using lithographic techniques, with subsequent ion etching is also a viable option. The profile as shown in Figure 5 is given as an example; other profiles are also possible, provided that EUV radiation is substantially not absorbed (i.e. is substantially transmissive), and diffraction of EUV radiation is small (e.g. less than about 30 % is diffracted).

Figure 5 shows by way of example a laminar square wave profile. However, this embodiment also comprises the configuration wherein a laminar sawtooth profile is used, or wherein a periodically structured sawtooth profile or periodically structured square wave profile is used.

In case a laminar sawtooth profile is used, the length 380 and height h of the protrusions, the period p in which the protrusions are arranged, and the angle ba, as well as the angle of incidence $\alpha$ may be chosen such that the projection beam PB only passes one protrusion.

Similarly this applies to the periodically structured profiles, however in such embodiment the period p comprises two periods, since a 2D structure is formed.

This embodiment may also comprise a profile wherein the protrusions have a length 380 that is smaller than half a period p (this is shown in figure 5 for the laminar arranged square wave profile but this may also apply for a sawtooth profile and for 2D profiles).

The protrusions on the mirror of this embodiment are mainly present as optical filter that is transmissive for EUV radiation.

### *Embodiment 3*

In a third embodiment, the profile of protrusions forms a grating, that may be optimised or blazed at the desired radiation, e.g. 13.5 nm or another EUV wavelength, as will be explained with reference to Figures 6 and 7. Alternatively, the grating may be optimised or blazed at other wavelengths, e.g. wavlengths in the UV, VIS or IR.

In Figure 6, a blazed grating has a sawtooth profile or mirror 300 with the grating constant p equal to the length 380 of a period of the sawtooth. $\alpha$ and $\beta$ are the angles under which the radiation beam PB may reach the surface of the protrusions on the surface and may be reflected by this surface, respectively. These angles are defined with respect to a normal n, normal on the surface of the mirror. The blaze angle can be chosen in such a way that the $0^{th}$ order of the grating is minimal for undesired radiation. Furthermore, it can be chosen in such a way that the diffraction efficiency of the desired radiation is maximised. With such an arrangement, a diffraction efficiency of 100% is theoretically possible (see e.g. EP 1197803, which is incorporated by reference). The height h and length 380 of the protrusions determine the efficiency of the 13.5 nm transmission. The grating constant p determines the wavelength range that is transmitted through the aperture 12 in figure 2 (see embodiment 1).

As an alternative to the blazed grating, a laminar grating of the type shown in Figure 7 may be used. As shown in Figure 7, the laminar grating has a square wave surface profile with the grating constant p equal to one period p of the square wave and equal to twice the length 380 of a protrusion. Such a grating may be made, e.g. using lithographic techniques. In such a technique, the upper surface is polished to a very good surface roughness and grooves are etched with the lands L defined by a photoresist pattern.

To extract the undesired longer-wavelength radiation (longer than the wavelength of the desired EUV radiation), a diffraction grating structure, such as consisting of a phase grating as shown in Figure 7, is applied to e.g. mirror 300. The grating is arranged so that the optical path difference (OPD) between rays having been reflected by the "land" L and "groove" G parts of the grating is an integer multiple of the wavelength of the desired wavelength, i.e.

$$OPD = m.\lambda_{euv} \qquad (1)$$

where n is an integer and $\lambda_{euv}$ the wavelength of the desired radiation, e.g. 13.5 nm. At the same time, for the OPD for the other radiation (undesired radiation), equation (1) generally does not hold. For example, for some wavelengths the OPD is an integer multiple plus half a wavelength in an undesired radiation range (as known from the art), i.e.

$$OPD = (m + 1/2). \lambda_{ud} \qquad (2)$$

where m is an integer and $\lambda_{ud}$ the wavelength of the undesired wavelength.

By satisfying equation (1), the grating does not disturb the desired radiation which is reflected as intended by mirror 300, effectively all desired or substantially all desired radiation is diffracted into the 0 order beam, since the grating is transmissive for the desired radiation (see also Figures 4 or 5). However, the undesired radiation is diffracted as determined by the grating equation and for wavelengths for which equation (2) is exactly satisfied the diffraction efficiency is at a maximum with all energy diffracted out of the 0 order beam (see also e.g. EP 1197803). In this way, the undesired radiation is spatially separated from the desired radiation forming projection beam PB and can be absorbed by a suitable heat sink or beam dump.

When a profile is selected having a grating structure, in a preferred further embodiment, the profile of protrusions forms a grating having a sawtooth profile, that is optimised for the deflection of undesired radiation. In another embodiment, when a profile is selected having a grating structure, the profile of protrusions forms a grating having a square wave profile, that is optimized at EUV wavelengths, e.g. 13.5 nm.

### Embodiment 4

In the embodiments above, a lithographic apparatus was described in general, and mirrors comprising one or more protrusions comprising a material selected from at least one of Be, B, C, P, S, K, Ca, Sc, Br, Rb, Sr, Y, Zr, Nb, Mo, Ba, La, Ce, Pr, Pa and U were described. In embodiment 4, a mirror is described comprising at least 2 different protrusions comprising two or more different materials, as will be explained with reference to Figures 8 and 9.

In this embodiment, a mirror 300 comprising one or more first protrusions LP1a and LP1b comprising a first material m1 selected from at least one of Be, B, C, P, S, K, Ca, Sc, Br, Rb, Sr, Y, Zr, Nb, Mo, Ba, La, Ce, Pr, Pa and U (protrusion LP1a), and comprising one or more second protrusions comprising a second material m2 selected from at least one of Be, B, C, Si, P, S, K, Ca, Sc, Br, Rb, Sr, Y, Zr, Nb, Mo, Ba, La, Ce, Pr, Pa and U (protrusion LP1b) is presented, and wherein the first and second materials are not the same, e.g. Si and Mo, Mo and Zr, C and Si, Be and Zr, etc. In another example, m1 is Be or Zr, and m2 is $Si_3N_4$ or $SiO_2$. When desired, also more materials than m1 and m2, and/or more protrusions than the first and second protrusions can be applied on a mirror 300.

In figure 8 a configuration of this embodiment is shown in more detail. It depicts a laminar sawtooth profile on mirror 300. In contrast to the sawtooth profiles shown in figures 3 and 6, the laminar sawtooth profile here comprises structures of two materials, The structure has a height h1, and comprises a first protrusion LP1a of a first material m1, with a blaze angle ba2 and a height h1, and a second protrusion LP1b of a second material m2 with a height h2 and with an angle ba3. These protrusions (of two or more materials) form together one protrusion or structure with a blaze angle ba. The protrusions may form a regular structure with period p. The protrusions on mirror 300, as shown in figure 8 may form a grating that may be blazed at EUV wavelengths, but in another embodiment they may also be blazed at other wavelengths, e.g. UV, VIS or IR wavelengths.

The blaze angle ba can be chosen in such a way that undesired radiation is deflected from the direction of the desired radiation, see above in embodiment 3 (figure 6). The blaze angle ba depends on angle ba2 of material m1 of the protrusion LPla (first protrusions), of an angle ba3 of material m2 of the protrusion LP1b (second protrusion), and of heights h1 and h2 of the protrusions LP1a and LP1b, which are in this case on top of each other.

As an alternative to the blazed profile, a laminar profile of the type shown in Figure 9 may be used. As shown in Figure 9, the laminar profile has a square wave surface profile with the constant p, equal to one period p of the laminar sawtooth profile shown in figure 8. The protrusions are located next to another in an alternating sequence and have different heights, viz. protrusion LPa of material m1 has height h1, and protrusion LP1b of material m2 has height h2. The lengths of the protrusions are shown in this figure by reference 380a for protrusion LP1a (first protrusion) of material m1 and by reference 380b for protrusion LP1b (second protrusion) of material m2. In Figure 9 lengths 380a and 380b are the same and the length of both when added is equal to period p.

By selecting the materials based on their index of refraction, heights h1 and h2, and when applicable lengths 380a and 380b or the angles ba, ba2 and ba3, distance (period p) of the first and second protrusions, and a certain angle of incidence of the projection beam on the mirror, a mirror can be obtained that reflects at a certain angle the desired radiation while correcting by the different materials the optical path length difference, such that it does not vary over the mirroring surface, whereas light of undesired wavelengths is absorbed and/or deflected at other angles.

By way of example this is shown in figure 9. Here, a ray r1 of projection beam PB enters a first P1a protrusion of material m1 and may substantially be transmitted through this protrusion and reflected at the mirror or mirror surface 300 on position 305. After being reflected, ray r1 leaves the protrusion. Ray r2, also comprised in projection beam PB, enters a first protrusion LP1b of material m2 and is reflected at position 306 at the mirror or on the mirror surface 300. Without the presence of this second protrusion LP1b, the optical path length (through the first and second protrusion and vacuum) is different for different rays. To compensate for this difference in optical path length, the second protrusion P1b of material m2 is present. This material m2 has another index of refraction. By choosing the appropriate dimensions of the protrusions and an angle of incidence, as mentioned above, the second protrusion LP1b of material m2 can compensate for the optical path difference for the (different rays in the) projection beam PB, thereby providing an optical path length difference that does not vary over the mirroring surface. This means that the optical path length difference is zero or an integer times the wavelength. The vacuum above the protrusions should also be taken into account for the determination of the optical path length (difference). In this way, the optical path lengths, i.e. pathlength times the indices of refraction are for rays r1 and r2, starting from wave front $WF_b$, before entering protrusions LP1a and LP1b, to wave front $WF_a$, after the protrusions protrusions LP1a and LP1b, are the same or the difference between the optical path lengths for rays r1 and r2 is an integer times the wavelength (e.g. 13.5 nm radiation). Hence, in this embodiment an optical path length difference is created for EUV radiation that does not vary over the mirroring surface.

For Si, having an index of refraction that is near unity for EUV radiation, the presence of such compensating second protrusions might be less necessary. However, when applying one of the other materials, the presence of the second protrusion LP1b might be especially beneficial. Nevertheless, also Si may create a small optical pathlength difference between the different rays (like shown for r1 and r2 in figure 9) within a projection beam PB, that might be compensated by the presence of second protrusions LP1b of Be, B, C, P, S, K, Ca, Sc, Br, Rb, Sr, Y, Zr, Nb, Mo, Ba, La, Ce, Pr, Pa and U

This embodiment also comprises a mirror having a mirroring surface (e.g. in a lithographic apparatus), wherein the protrusions are arranged in such a way that a part of EUV radiation of a projection beam comprising EUV radiation, having an angle of incidence between 0 and 90°, only passes in one period p one first protrusion LP1a (of material m1) and one second protrusion LP1b (of material m2), analogous to embodiment 2. This means that the length of the protrusions 380a and 380b is smaller than the period p (analogous to embodiment 2, or embodiment 7, wherein the length 1 of the protrusion is smaller than half a period p (groove G and land L form one period in embodiment 2)).

This embodiment also comprises a mirror wherein the profile of protrusions forms a grating, that is blazed (sawtooth) or optimised (square wave) at the desired radiation, e.g. 13.5 nm or another wavelength. Profiles of these type on mirrors may have a 1D or 2D character. Since these protrusions are transparent to EUV radiation, the desired wavelengths are reflected by the mirror 300, and the undesired wavelengths of the radiation are absorbed, refracted and/or deflected.

In general, this embodiment describes a mirror, having at least one mirroring surface 300, wherein the mirroring surface 300 comprises one or more protrusions P1a comprising a first material m1 (first protrusions), and comprising one or more protrusions LP1b comprising a second material m2 (second protrusions), and wherein the first and second materials are not the same. Such a mirror 300 can be used as an optical filter, when the materials that are used are transparent for the desired wavelength, or optimised to be transparent for the desired wavelengths. Other wavelengths, not desired wavelengths, may be absorbed by the materials, and when a grating for a certain wavelength is chosen (grating or blazed grating), the undesired wavelengths might also be (partially) deflected.

This embodiment also comprises a lithographic apparatus (see e.g. embodiment 1) comprising the mirror as described in this embodiment.

For providing the above described structures, the blazed structure may be provided by ruling a layer of material m1 with a diamond tool, depositing material m2, and ruling with a diamond tool for a second time. For the square shaped structures, a lithographic process may be used.

The next embodiments, embodiments 5-11, describe some further or specific features that might be comprised in the mirrors described in the embodiments above.

### Embodiment 5

In this embodiment, the mirror 300 according to the invention (e.g. described in one of the above-mentioned embodiments), is provided with a cooling element which is in thermal contact with the mirror (see e.g. figure 2 of EP 1197803). To cool the mirror of one of the previous embodiments in use, cooling channels can be provided on the rear surface of the mirrors, or incorporated in the body of the mirror. A suitable coolant fluid is passed through the cooling channels to maintain the mirror at a desired temperature.

### Embodiment 6

In this embodiment, the mirror 300 according to the invention is a multilayer mirror, having protrusions of different materials according to embodiment 4.

### Embodiment 7

In this embodiment, the mirror 300 according to the invention comprises a mirror as described in embodiment 2 (amongst others, figure 5), but wherein length 380 of the protrusions (references LP1, LP2 etc. in figure 4; reference 301 in figure 5) « period p of the protrusions. In this way, possible diffractive loses of the desired radiation at the top surfaces of the protrusions is minimised. For example, the ratio length 380 : p is equal or smaller than 1:5, e.g. the length 380 of the protrusion is 150 nm and the period p is 1250 nm. In a further embodiment, the projection beam passes exactly only one protrusion. The materials of the protrusions 301 in figure 5 can be selected from Be, B, C, Si, P, S, K, Ca, Sc, Br, Rb, Sr, Y, Zr, Nb, Mo, Ba, La, Ce, Pr, Pa and U. For example, B, C, Mo, Nb or Si can be chosen, but also $Si_3N_4$. Also combinations of materials can be chosen, e.g. $B_4C$ or SiC.

### Embodiment 8

In this embodiment, the mirror 300 according to the invention is a grazing incidence reflector. The the angle of incidence with respect to the mirroring surface may be around 75 to 85° (see e.g $\alpha$ in figure 6). In this embodiment, the protrusions, either as single protrusions, or as first and second protrusions, are present on radiation collector 10 (see Figure 2). In general, for an optical filter according to the invention it is beneficial to have the mirror with the protrusions before the beam is focussed, as it is in the virtual source point 12 (see embodiment 1, figure 2).

### Embodiment 9

In this embodiment, the protrusions, either as single protrusions or as first and second protrusions, are present on mirror 11 of Figure 2

### Embodiment 10

In this embodiment, the protrusions, either as single protrusions, or as first and second protrusions, are present on normal incidence mirrors 13 or 14

### Embodiment 11

In this embodiment, the radiation that is used, e.g. in a projection beam PB of a lithographic apparatus, comprises extreme ultraviolet radiation, e.g. having a wavelength in the range of from 8 to 20 nm, especially 9 to 16 nm, e.g. 13.5 nm.

Whilst specific embodiments of the invention have been described above, it will be appreciated that the invention may be practised otherwise than as described. The description of the embodiments and the Figures are not intended to limit the invention. For example, the invention is not confined to the lithographic apparatus as described in the first embodiment.

### Claims

1. A mirror, having a mirroring surface, **characterised in that** the mirroring surface comprises one or more protrusions comprising a material selected from at least one of Be, B, C, P, S, K, Ca, Sc, Br, Rb, Sr, Y, Zr, Nb, Mo, Ba, La, Ce, Pr, Pa and U.

2. Mirror according to claim 1, wherein the protrusions are arranged in such a way that a part of EUV radiation of a projection beam comprising EUV radiation, having an angle of incidence between 0 and 90°, only passes one protrusion.

3. Mirror according to claim 1 or 2, wherein the protrusions, having a length and a period, are arranged in such a way that the length of the protrusions « the period of the protrusions.

4. Mirror, having a mirroring surface, wherein the mirroring surface comprises one or more first protrusions comprising a first material, and comprising one or more second protrusions comprising a second material, and wherein the first and second materials are not the same.

5. Mirror according to one of claims 1-4, having at least one mirroring surface, wherein the mirroring surface comprises one or more first protrusions comprising a first material selected from at least one of Be, B, C, P, S, K, Ca, Sc, Br, Rb, Sr, Y, Zr, Nb, Mo, Ba, La, Ce, Pr, Pa and U, and one or more second protrusions comprising a second material selected from at least one of Be, B, C, Si, P, S, K, Ca, Sc, Br, Rb, Sr, Y, Zr, Nb, Mo, Ba, La, Ce, Pr, Pa and U, and wherein the first and second materials are not the same.

6. Mirror according to claims 4 or 5, wherein the first protrusions and second protrusions are arranged in such a way that for EUV radiation an optical path length difference is created that does not vary over the mirroring surface.

**7.** Mirror according to one of claims 1-6, wherein the mirror is a grazing incidence mirror or a multilayer mirror.

**8.** A lithographic projection apparatus comprising:

- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- one or more mirrors, each mirror having a mirroring surface,

**characterised in that** at least one of the mirrors comprises a mirror according to one of claims 1-7.

**9.** Lithographic apparatus according to claim 8, comprising a mirror having a mirroring surface comprising first and second protrusions, wherein the first protrusions and second protrusions are arranged in such a way that for EUV radiation an optical path length difference is created that does not vary over the mirroring surface.

**10.** A device manufacturing method comprising:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; and
- providing one or more mirrors, having a mirroring surface,

**characterised by** providing in the projection beam (PB) at least one mirror according to one of claims 1-7.

**11.** Mirror according to one of claims 1-7, wherein the protrusions are arranged in such a way that when beam of radiation is radiated on the mirror, desired wavelengths of the beam of radiation are passed and undesired wavelengths are deflected and/or absorbed.

**12.** Mirror according to one of claims 1-7 or 11, wherein the protrusions are arranged to form a blazed grating.

**13.** Lithographic apparatus according to claims 8 or 9, wherein one or more of mirrors are arranged close to the radiation system.

**14.** Method according to claim 10, wherein a mirror having a mirroring surface comprising first and second protrusions is provided, wherein the first protrusions and second protrusions are arranged in such a way that for EUV radiation an optical path length difference is created that does not vary over the mirroring surface.

**15.** A device manufactured according to the method of one of claims 10 or 13, or with the apparatus according to one of claims 8, 9 or 12.

## Fig 1

## Fig 2

# Fig 3

# Fig 4

# Fig 5

# Fig 6

# Fig 7

## Fig 8

## Fig 9

**European Patent Office**

## EUROPEAN SEARCH REPORT

Application Number

EP 03 07 7155

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2003/002622 A1 (MARTYNOV VLADIMIR V ET AL) 2 January 2003 (2003-01-02) <br> * paragraph '0021! – paragraph '0027! * <br> * figure 2 * | 1-3 | G21K1/06 <br> G02B1/00 <br> G02B5/18 |
| X | US 2003/058529 A1 (GOLDSTEIN MICHAEL) 27 March 2003 (2003-03-27) <br> * paragraph '0015! – paragraph '0046! * <br> * figures 2,3,6 * | 1-3 | |
| X | US 4 915 463 A (BARBEE JR TROY W) 10 April 1990 (1990-04-10) | 4-7,11, 12 | |
| Y | * column 1, line 11 – column 1, line 53 * <br><br> * column 3, line 32 – column 6, line 62 * <br> * column 8, line 27 – column 10, line 40 * | 8-10, 13-15 | |
| Y | US 6 118 577 A (RAY-CHAUDHURL AVIJIT K ET AL) 12 September 2000 (2000-09-12) <br> * the whole document * | 8-10, 13-15 | |
| X | US 3 045 532 A (STAUNTON JOHN J J) 24 July 1962 (1962-07-24) <br> * column 1, line 14 – column 4, line 24; figure 5 * | 4,7,11, 12 | TECHNICAL FIELDS SEARCHED (Int.Cl.7) <br><br> G21K <br> G02B |
| X | US 3 046 839 A (PARRISH JR MAXFIELD ET AL) 31 July 1962 (1962-07-31) <br> * column 1, line 33 – column 6, line 37; figures 1,3,4 * | 4,7,11, 12 | |
| X | US 3 942 873 A (SHIMOTAKAHARA TSUMORU) 9 March 1976 (1976-03-09) <br> * the whole document * | 4,7,11, 12 | |

-/--

The present search report has been drawn up for all claims

| Place of search | Date of completion of the search | Examiner |
|---|---|---|
| Munich | 15 July 2004 | Korb, W |

17

**European Patent Office**

## EUROPEAN SEARCH REPORT

Application Number

EP 03 07 7155

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | SEAN ROSS T ET AL: "FABRICATION PROCESS FOR MULTILAYER X-RAY PHASE GRATINGS" OPTICAL ENGINEERING, SOC. OF PHOTO-OPTICAL INSTRUMENTATION ENGINEERS. BELLINGHAM, US, vol. 29, no. 7, 1 July 1990 (1990-07-01), pages 728-732, XP000140664 ISSN: 0091-3286 * the whole document * | 1-15 | |

TECHNICAL FIELDS SEARCHED (Int.Cl.7)

The present search report has been drawn up for all claims

| Place of search | Date of completion of the search | Examiner |
|---|---|---|
| Munich | 15 July 2004 | Korb, W |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

European Patent
Office

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

| | | | |
|---|---|---|---|
| **European Patent** **Office** | **LACK OF UNITY OF INVENTION** **SHEET B** | **Application Number** **EP 03 07 7155** |

The Search Division considers that the present European patent application does not comply with the requirements of unity of invention and relates to several inventions or groups of inventions, namely:

1. claims: 1 - 3

   A mirror having a mirror surface which comprises protrusions comprising a material selected from at least one of Be, B, C, P, S, K, Ca, Sc, Br, Rb, Sr, Y, Zr, Nb, Mo, Ba, La, Ce, Pr, Pa and U.
   ---

2. claims: 4 - 15

   A mirror having a mirror surface comprising protrusions of a first material and protrusions of a second material wherein the first and secon materials are not the same.
   ---

## ANNEX TO THE EUROPEAN SEARCH REPORT
## ON EUROPEAN PATENT APPLICATION NO.

EP 03 07 7155

This annex lists the patent family members relating to the patent documents cited in the above-mentioned European search report.
The members are as contained in the European Patent Office EDP file on
The European Patent Office is in no way liable for these particulars which are merely given for the purpose of information.

15-07-2004

| Patent document cited in search report | | Publication date | Patent family member(s) | | Publication date |
|---|---|---|---|---|---|
| US 2003002622 | A1 | 02-01-2003 | EP | 1399927 A1 | 24-03-2004 |
| | | | WO | 03003380 A1 | 09-01-2003 |
| | | | US | 2003072412 A1 | 17-04-2003 |
| US 2003058529 | A1 | 27-03-2003 | US | 2003206340 A1 | 06-11-2003 |
| | | | US | 2003202239 A1 | 30-10-2003 |
| | | | US | 2003202240 A1 | 30-10-2003 |
| US 4915463 | A | 10-04-1990 | NONE | | |
| US 6118577 | A | 12-09-2000 | AU | 3788499 A | 28-02-2000 |
| | | | DE | 1103018 T1 | 07-02-2002 |
| | | | EP | 1103018 A1 | 30-05-2001 |
| | | | JP | 2002522898 T | 23-07-2002 |
| | | | WO | 0008526 A1 | 17-02-2000 |
| | | | US | 6210865 B1 | 03-04-2001 |
| | | | US | 6225027 B1 | 01-05-2001 |
| | | | US | 6285497 B1 | 04-09-2001 |
| | | | US | 6469827 B1 | 22-10-2002 |
| US 3045532 | A | 24-07-1962 | NONE | | |
| US 3046839 | A | 31-07-1962 | NONE | | |
| US 3942873 | A | 09-03-1976 | JP | 50092148 A | 23-07-1975 |

EPO FORM P0459

For more details about this annex : see Official Journal of the European Patent Office, No. 12/82